(19) Europäisches Patentamt
European Patent Office
Office européen des brevets

(11) Publication number : 0 386 969 B1

(12) # EUROPEAN PATENT SPECIFICATION

(45) Date of publication of patent specification : 07.12.94 Bulletin 94/49

(51) Int. Cl.$^5$ : H01L 39/24, C04B 41/50

(21) Application number : 90302293.7

(22) Date of filing : 05.03.90

(54) **Method for protective coating superconductors.**

(30) Priority : 09.03.89 US 320986

(43) Date of publication of application : 12.09.90 Bulletin 90/37

(45) Publication of the grant of the patent : 07.12.94 Bulletin 94/49

(84) Designated Contracting States : BE DE ES FR GB NL

(56) References cited :
EP-A- 0 301 962
WO-A-89/10909

(73) Proprietor : DOW CORNING CORPORATION
3901 S. Saginaw Road
Midland Michigan 48686-0994 (US)

(72) Inventor : Baney, Ronald Howard
5704 Lantern Lane
Midland, Michigan (US)
Inventor : Bergstrom, Debora Frances
517 W. Meadowbrook
Midland, Michigan (US)
Inventor : Carpenter, Leslie Earl
2508 Abbott Road,
Apt. Q-11
Midland, Michigan (US)

(74) Representative : Lewin, John Harvey et al
Elkington and Fife
Prospect House
8 Pembroke Road
Sevenoaks, Kent TN13 1XR (GB)

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 386 969 B1

## Description

The present invention relates to high temperature superconductors and especially so-called cuprate or copper-oxide containing superconductors. The most common is the so-called "1-2-3" cuprate, which comprises $Y_1Ba_2Cu_3O_{(7-d)}$, where d is not greater than .5.

Cuprate superconductors have been found to react with water, carbon dioxide and organic compounds. The phase changes resulting from these reactions destroy the high temperature superconducting properties of this material. The use of this new superconducting material in high surface-to-volume applications such as fibers and thin films, in devices like Josephson junctions, superconducting quantum interference devices and superconductor hybrid transistors, requires the development of a method to protect the superconductor from the environmental contaminants which are capable of destroying it.

Several methods have been established in efforts to protect the superconductor. Perhaps the earliest attempt to protect the "1-2-3" superconductor employed an epoxy polymer. It was found to be only marginally effective. It has since been found that the $Y_1Ba_2Cu_3O_{(7-d)}$ superconductor can react with polymer matrices. A second approach to protecting the superconductor, although it does not involve a protective coating, involved the discovery that the incorporation of fluorine into the superconductor solid-state structure at a doping level seemed to provide added stability to the material. Since this method does not involve a hermetic coating it will not act as a gas or moisture diffusion barrier and is likely to be insufficient protection for the superconductor. A third technique used the inert noble metals Au and Ag as a passivating layer. The noble metal coatings have been shown to be unreactive in the presence of the superconductor, however, application of these coatings on a large scale may become prohibitively expensive.

Following this trend toward materials which are inert toward chemical oxidation, new methods have been developed to apply overlayers of $CaF_2$ and the oxides of Bi, Al and Si using vacuum deposition techniques. Bi, Al and Si were deposited in an activated $O_2$ stream to convert the elements to the oxides. Most recently, Fujitsu LTD has claimed to have made an effective fluorinated organic protective film using reactive polymerization of carbon with fluorine in a high frequency plasma.

The last two methods described above, using vacuum deposition and high frequency plasmas, have the disadvantage of being difficult to implement. Vacuum deposition is also slow and has difficulty covering substrates of complex shapes. Any high energy method such as plasma deposition has the probability of being higher in cost.

In the present invention, we have discovered that cuprate superconductors can be protected against deleterious reactions by coating the superconductor material with an organic solution of a continuous film forming silica precursor. The organic solvent must volatilize at temperatures below 400°C. and below any temperature at which the solvent would significantly react with the cuprate superconductor. The solvent is evaporated off of the superconductor and the coating is pyrolyzed to a silica coating in oxygen at an elevated temperature in the range from 300°C to 400°C.

It is important that the silica precursor form a continuous film when applied to the superconductor material. Examples of suitable film-forming silica precursors include the silsesquioxanes, ethyl polysilicate and tetraethyl orthosilicate. Colloidal silica may be added to the film forming composition as a secondary ingredient, but colloidal silica per se does not form a suitable continuous film when applied to the superconductor.

Silsesquioxanes useful as the continuous film-forming silica precursor in the present invention have the general formula: $(RSiO_{3/2})_n$. R comprises a hydrogen atom, a hydroxy group, a low carbon alkyl or low carbon alkenyl group or a low carbon alkoxy group. R can be a different one of the foregoing at different points along the length of the polymer chain. n is within the range of 5 to 100. "Low carbon" is e.g. $C_1$-$C_6$.

Hydrido silsesquioxane (precursor I), is an example of a silsesquioxane in which R equals hydrogen. The preparation of precursor I is known in the art. One known method involves the condensation of trichloro-, trimethoxy- or triacetoxysilanes in a sulfuric acid medium. This method is disclosed in United States Patent No. 3,615,272, entitled CONDENSED SOLUBLE HYDROGEN SILSESQUIOXANE RESIN, issued to Collins and Frye on October 26, 1971.

Precursors II comprise compositions containing silsesquioxane wherein R is a low carbon alkyl, alkenyl or alkoxy group. Precursors II and their preparation are known in the art. United States Patent No. 3,986,997 to Clark, entitled PIGMENT FREE COATING COMPOSITIONS, issued June 25, 1974, discloses such precursor II compositions.

Secondary active ingredients such as colloidal silica can also be added to the solution. The precursors II disclosed in United States Patent No. 3,986,997 discussed above include an acidic dispersion of colloidal silica in the precursors II solutions.

So-called "Accuglass™" also comprises a suitable precursor for use as the principal ingredient of the present invention, wherein colloidal silica may be added as a secondary active ingredient. Accuglass™ is also believed to be an example of a silsesquioxane based coating in which the "R" groups on the polymer backbone are mixed. The R groups comprise either methyl groups, ethoxy groups or hydroxy groups at different points along the length of the polymer backbone.

A wide range of organic solvents are suitable for use in the present invention. Examples include: n-heptane, alcohol, acetone, toluene, isopropyl alcohol, propylene glycol monomethyl ether, propanol, etc. These are examples of solvents which will not react with the superconductor or which will volatilize at temperatures below any temperature at which they would significantly react with the cuprate superconductor and which evaporate at temperatures below 400°C.

The solids ($SiO_2$) concentration of the coating solutions should be from about 10 to about 50%. Modest experimentation will reveal the optimum concentration for different continuous film forming silica precursors or different cuprate superconductor coating applications.

The cuprate superconductors may be in the form of film, fiber, powder or bulk material. The specific coating technique may vary depending on which form the superconductor is in. The expected similar reactivity of the various cuprate superconductors indicates the operability of the present invention on cuprate superconductors in general.

Pyrolysis of the coating can be achieved by any known heating methods such as radiant, microwave, induction or laser heating or rapid thermal processing. Generally, heating is required for an amount of time and at a temperature to convert sufficient precursor to silica to provide protection for the superconductor.

Any temperature sufficient to accomplish conversion to silica is within the scope of this invention. Temperature may vary with precursor and heating method. For example, suitable conversions have been achieved using radiant heating at temperatures between 300 and 400°C. for about one hour.

The pyrolysis atmosphere must contain oxygen to facilitate conversion of the precursor to silica and prevent loss of oxygen from the superconductor. The atmosphere may contain other inert components such as nitrogen.

In a series of experiments, the continuous film forming silica precursor solutions useful in the present invention were compared to other film forming protective coatings for cuprate superconductors. The cuprate superconductor starting material was a loose, regenerated yttrium barium cuprate powder.

Experiment 1:

In this experiment, precursor I continuous film coating was compared to $Si_3N_4$ precursor, an alkylated siloxane polymer of the formula:

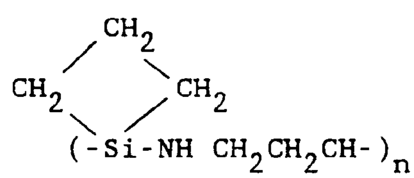

The specific procedures followed were as follows:

Preparation of the $Y_1Ba_2Cu_3O_{(7-d)}$ Powder: The yttrium barium copper oxide superconducting powder, $Y_1Ba_2Cu_3O_{(7-d)}$, used in this work was obtained from Grace Division of Davison Chemical Company. Prior to use, the superconducting properties of the yttrium barium cuprate powder were assessed by levitation experiments. To check the materials ability to levitate, that is expel a magnetic field, a 13mm pressed pellet of the superconducting powder was formed by compressing the powder in a hardened steel die at 14,000 pounds of pressure. This pressed pellet was cooled in liquid nitrogen. It was then placed above similarly cooled magnets. If the superconductor pellet remained suspended above the magnets, the Meissner effect was demonstrated and the superconducting phase was intact. If the Meissner test failed, the superconductor was regenerated by heating to 950°C. for one hour and then cooling to and holding at 450°C. for 18 hours, all under the continual flow of oxygen.

Hydrido silsesquioxane precursor I: A precursor I solution was made to a 10% solids concentration by the dissolution of 1.0g of hydrido silsesquioxane in 9.0g of n-heptane. To this was added 0.1g of a platinum catalyst solution which consisted of 0.1166% by weight platinum (in the form of platinum acetate) in a dry toluene solution. To this solution was added 1.0g of the superconductor powder. The mixture was mechanically shaken for 10 minutes. The solution was then centrifuged for 15 minutes. The supernatant was drawn off and the wet solid was dried in a desiccator overnight. The dried sample was heated to 400°C. in a tube furnace under oxygen flow for three hours and was then cooled. A pellet was formed and the pellet was reheated to 700°C. for

one hour and then cooled to 400°C. for 18 hours under oxygen flow.

$Si_3N_4$ precursor, an alkylated siloxane polymer was made to a 10% by weight solids solution using toluene as the solvent. In this case, the pellets were formed before the coating was applied. In order to expel trapped gasses from within the pellet and thus achieve a more thorough coating, a vacuum infiltration procedure was used. In this vacuum infiltration procedure, the pellets were placed in the coating solution in a flask and the flask was repeatedly subjected first to vacuum, then to nitrogen pressure using Schlenk techniques. The Pellets were left in contact with the $Si_3N_4$ precursor polymer solution for two hours. The pellets were then fired in ammonia for one hour at 400°C.

Procedure: The coated superconductor pellets prepared in the manners set forth above were compared to uncoated pellets. For each sample, the samples were analyzed on a magnetometer after coating and after exposure to 85% relative humidity at 85°C. for two hours. The measurements gave numbers for the magnetic moments of the samples, which were then converted to the gram magnetic susceptibility by dividing the weight of the sample by the magnetic field at which the measurement was done. The magnetic moment measurements were done at a magnetic field of 61 Gauss and a temperature of 4K. The percent of diamagnetic susceptibility retained following coating and following exposure to the 85/85 conditions are set forth below in Table 1:

TABLE 1

Percent of Susceptibility Retained
Following Coating and Exposure to 85/85

| Coating Applied | After Coating | After Exposure | Total |
|---|---|---|---|
| No coating | ---- | 9.19 | 9.19 |
| Precursor I | 86.7 | 23.9 | 20.7 |
| $Si_3N_4$ precursor | 2.60 | 0.0 | 0.0 |

As can be seen, the percent diamagnetic susceptibility retained after coating and after exposure was far greater using the method of the present invention, as compared to coating with the $Si_3N_4$ precursor. The percent magnetic susceptibility retained was also far superior to that retained by the uncoated control following exposure to 85/85.

Experiment 2:

In this second set of coating experiments, all of the coatings were applied to pressed pellets, not loose powders. The pellets were formed by pressing at 16,000 pounds for one minute in the same 13mm die. The platinum catalyst was no longer used in the coating solutions. The coatings were all applied using the vacuum infiltration procedure described above. This set of coating experiments was done in two separate runs, but the procedure did not vary appreciably between the two runs. The coating procedures follow:

RUN 1

1. Polystyrene

A solution of polystyrene was prepared using 1.3g of polystyrene in 11.7g of toluene to give a solution of a concentration of 10% by weight of solids. The coated pellets were removed from solution and were then dried under vacuum.

2. Accuglass™

Accuglass™ coatings used an Allied-Signal spin-on glass known as Accuglass™ #305 which is described as an ethoxymethylpolysiloxane $[SiO_a(CH_3)_b(OC_2H_5)_c(OH)_d]_n$ where a is one or more, b is one-half or less, c+d is one-half or less and n is 5-100. The Accuglass™ solution employed contains less than 20 weight percent solids in a solution of alcohol/acetone. Pressed pellets were coated with Accuglass™ solution. The coated pellets were pyrolyzed at 400°C. under a slow flow of oxygen for a period of two hours and then were allowed to cool.

3. Precursor I

A solution of precursor I was made using 1.7g of hydrido silsesquioxane in 15.2g of toluene, to form 10% solids solution. The coated samples were drained and pyrolyzed at 400°C. under oxygen flow for one hour. The samples were then allowed to cool to room temperature.
Procedure: This set of newly coated samples, plus samples from the first set of experiments which were coated with $Si_3N_4$ precursor and uncoated samples, were subjected to the 85% relative humidity and 85°C. accelerated stress test for one hour. The samples were analyzed by magnetic susceptibility measurements. In this case, the magnetic moment was divided by the volume of the sample resulting in the volume susceptibility. The magnetic moments were measured at a magnetic field of 61 Gauss and at a temperature of 20K. Prior to the magnetic susceptibility measurements, the coated pellets were cut into smaller measurement-size pieces using a water-cooled diamond saw.

The percent of diamagnetic susceptibility retained by the samples following coating and exposure to 85/85 is reported in Table 2 below:

TABLE 2

Experiment 2, Run 1
Percent of Susceptibility Retained
Following Coating and Exposure to 85/85

| Coating Applied | After Coating | After Exposure | Total |
|---|---|---|---|
| No coating | ---- | 47.7 | 47.7 |
| Accuglass™ | 80.5 | 96.9 | 78.0 |
| Precursor I | 88.4 | 88.9 | 78.7 |
| Polystyrene | 100 | 52.1 | 52.1 |
| $Si_3N_4$ precursor | 0.0 | 0.0 | 0.0 |

It can be seen that the cuprate superconductors coated with Accuglass™ and precursor I in accordance with the present invention retained far more diamagnetic susceptibility than did the control (no coating) or the samples coated with polystyrene or $Si_3N_4$ precursor. The sample coated with $Si_3N_4$ precursor performed worse than the control, whereas the sample coated with polystyrene performed comparably to the control.

RUN 2

1. Organosiloxane I

Organosiloxane I is a resin containing 30 mol percent phenylsilsesquioxane, 35 mol percent phenylmethylpolysiloxane, 25 mol percent methylsilsesquioxane and 10 mol percent dimethylpolysiloxane in a 50% by weight total solids solution in xylene. To 1.5g of the organosiloxane I was added 15.0g of toluene to form a 10% by weight solids solution. The superconductor pellet was added to this solution and vacuum infiltration was done as before. The pellet was allowed to remain in the resin solution overnight. The samples were then removed, drained and pyrolyzed in oxygen at 250°C. for one hour. The samples were cooled. The coated samples were still able to levitate at the liquid nitrogen temperature.

2. Polycarbosilane

A polycarbosilane solution was made 10% by weight solids by adding 1.5g of polycarbosilane to 15.1g of toluene. Polycarbosilanes are known as silicon carbide precursors. The pellets were placed in the solution and vacuum infiltrated. The samples were allowed to remain in the solution overnight. They were then drained and pyrolyzed in argon at 400°C. for one hour. Following the coating procedure, the pellets were found to no longer exhibit the Meissner effect.

3. Polycarbosilane, regenerated

When it was observed that the superconductor pellets which were coated with polycarbosilane no longer

exhibited the Meissner effect, some of the polycarbosilane coated samples were regenerated. This regeneration was done by pyrolyzing the samples in oxygen according to the 950°C. heating regimen which was used to regenerate the powder as described in the powder preparation step above. Following the application of the regeneration procedure on the polycarbosilane coated samples, the samples again had the ability to levitate.

4. $Si_3N_4$ precursor

The 10% $Si_3N_4$ precursor solution made in the first set of coating experiments was used to coat new samples. The pellets were submerged in the solution, vacuum infiltrated and allowed to remain in the solution overnight. The following day the samples were removed, drained, pyrolyzed in ammonia in a glove box at 400°C. for one hour and cooled. The pellets were found to no longer levitate after application of the $Si_3N_4$ precursor coating.

5. $Si_3N_4$ precursor, regenerated

The samples which were coated with $Si_3N_4$ precursor and no longer showed the Meissner effect were regenerated in the same manner as the regenerated polycarbosilane coated samples described immediately above. Following the regeneration procedure, the samples showed the Meissner levitation effect.

Procedure: These coated pellets from Run 2 of the second set of coating experiments, plus uncoated pellets, were subjected to 85% relative humidity and 85°C. temperature for a period of one hour. The pellets were then cut into small rectangular pieces, for magnetic susceptibility measurements, using a diamond saw cooled with Fluorinert FC-72 Liquid by 3M Company. In order to cut the 13mm disc shaped pellets, a chuck for a Buehler Isomet low speed saw was modified to fit a graphite block. The pressed pellet of superconductor was attached to the graphite block by heating the block on a hot plate and melting a strip of 70°C. Lakeside Adhesive to the graphite. To the adhesive was attached the superconductor pellet. During the cutting, an inert coolant was used in order to avoid the damaging effects of the previous water cooled cutting procedure. Following the cutting procedure, the graphite block was again heated until the pellet pieces were released. The pellet pieces were then ground slightly on a piece of 400 grit silicon carbide paper to get rid of any traces of adhesive.

The magnetic susceptibility measurements were again done. The volume susceptibility was calculated from the magnet moment. The measurements were done at 200 Gauss magnetic field and at 20K and 100K temperatures. The measurement of the magnetic susceptibility required the validation of the positions of the samples in the magnetic field prior to the measurement of the susceptibility. This validation was done at 100K except for the $Si_3N_4$ precursor and $Si_3N_4$ precursor regenerated samples, where the magnetic susceptibility signal was very weak. For these two samples the sample position was validated at 20K.

As in the above runs, percent of diamagnetic susceptibility retained was determined and is set forth in Table 3 below:

TABLE 3

Experiment 2, Run 2
Percent of Susceptibility Retained at 20K
Following Coating and Exposure to 85/85

| Coating Applied | After Coating | After Exposure | Total |
|---|---|---|---|
| Uncoated | ---- | 43.8 | 43.8 |
| $Si_3N_4$ precursor | 0.22 | 0 | 0 |
| $Si_3N_4$ regen. | 73.0* | 50.8 | 37.1 |
| Organosiloxane I | 71.4 | 44.5 | 31.8 |
| Polycarbosilane | 74.6 | 48.4 | 36.1 |
| Polycarb. regen. | 95.1* | 61.4 | 58.4 |

*and regeneration.

In Experiment 2, Run 2, none of the samples were coated in accordance with the present invention. It will be noted that none of the samples performed much better than the uncoated control and most performed worse. The use of polycarbosilane has a great drawback in that the samples lose all of their superconductivity

during the coating process. The coated samples have to be regenerated by pyrolyzing in oxygen at 950°C. in order to regain any diamagnetic susceptibility.

Experiment 3:

Third Coating Experiments: In the third set of coating experiments, several changes were made in the overall procedure which would improve the reliability of the experimental results. The pellets were pressed using the same weighed amount of powder for each pellet to eliminate some of the variability in the pellet thicknesses. Before each pellet was pressed, the die was cleaned with Stephenson Release Agent Dry Lubricant to prevent sticking and crumbling of the pellet. Pellets were pressed at 14,000 pounds for one minute each.

In all previous experiments, the pellet was coated first and then cut. This causes uncoated edges to be exposed to the environment before the analyses are complete. In this third set of experiments, the pellets are formed, then cut and then coated. There should be no exposed edges after coating.

With the variations in the coating application times and pyrolysis temperatures, times and atmospheres, plus the variability in the pellets themselves, it became difficult to isolate the effects due to the pellet making and coating process from the effects due to the coating performance. In order to factor out the effects due to variations in individual pellets and coating processes, each pellet formed was cut into three pieces. A given coating was evaluated using three pieces cut from a single pellet. Of these three pieces, one piece was left uncoated and unstressed as a control. A second piece was coated but not stressed and the third was coated and stressed.

To further control the experiment, processing conditions were made as similar as possible. In this set of coating experiments, all of the coatings were applied by vacuum infiltration of the peices in the coating solution followed by a 1.5 to 2 hour immersion time. All of the coated pieces were stored in a dessicator until pyrolysis. There was some variation in the length of time a sample was stored ranging from 2 to 4 days. The samples were then pyrolyzed for one hour under oxygen flow at 400°C. In fact, the coatings were pyrolyzed in a single batch for each of the two runs, except for a few cases. The coated samples and an uncoated control sample were all exposed to 85% relative humidity and 85°C. for one hour in single batch runs also. The coating solutions used are described below.

RUN 1

1. Accuglass™

Accuglass™ spin-on glass #305 was used as obtained from Allied-Signal. A new lot of the material was obtained from the manufacturer for this set of experiments.

2. Precursor I

The precursor I solution used in these experiments was a 10% solids solution of hydrido silsesquioxane in toluene prepared as described in previous experiments.

3. Precursor II-A

Precursor II-A is used to describe a 10% solids solution in isopropyl alcohol and propyleneglycol monomethylether, where the solids are made up of methylsilsesquioxane and colloidal silica. The solids in the precursor II-A solution were 10% by weight methylsilsesquioxane and 90% by weight colloidal silica. The methylsilsesquioxane was made by the partial hydrolysis of methyltri(methoxy)silane monomer with water. The colloidal silica used was a 34% colloidal suspension in water.

4. Precursor II-B

This solution was made in a very similar manner to the precursor II-A solution described above. Again the total solids in solution are 10% by weight and the solvents are isopropyl alcohol and propyleneglycol monomethylether. In this solution, however, the solids are made up of 80% methylsilsesquioxane and 20% colloidal silica.

Following the application of the coatings and the stress testing, the magnetic susceptibilities of the samples were measured as before. The magnet moment measurements were done at two temperatures, 20K and 100K, allowing the observation of the superconducting transition. The magnetic field used for the measurements was 200 Gauss.

As above, magnetic susceptibilities were determined after coating and after exposure to 85/85. In this example, all of the superconductors were coated in accordance with the process of the present invention, except for the uncoated control. It can be seen that all of the coated samples retained a significantly higher percentage of their diamagnetic susceptibility and superconductivity than did the uncoated control.

TABLE 4

Experiment 3
Percent of Susceptibility Retained
Following Coating and Exposure to 85/85

| Coating Applied | After Coating | After Exposure | Total |
|---|---|---|---|
| Accuglass™ | 81.5 | 97.3 | 79.3 |
| Precursor I | 87.9 | 93.7 | 82.4 |
| Precursor II-B | 90.6 | 107.3 | 97.2 |
| Precursor II-A | 61.1 | 98.3 | 60.1 |
| Uncoated | ---- | 46.4 | 46.4 |

## Claims

1. A method for protecting cuprate superconductors comprising:
coating the superconductor material with an organic solution of a continuous film-forming silica precursor, the organic solvent for said solution being one which will volatilize at temperatures below 400°C and below any temperature at which the solvent would significantly react with the cuprate superconductor;
evaporating said solvent off of said coated superconductor; and
pyrolyzing said coating to silica in an atmosphere containing oxygen at an elevated temperature in the range from 300°C to 400°C.

2. The method of claim 1 in which said continuous film-forming silica precursor comprises tetraethyl orthosilicate.

3. The method of claim 2 in which said continuous film-forming silica precursor also includes colloidal silica.

4. The method of claim 1 in which said continuous film-forming silica precursor comprises ethyl polysilicate.

5. The method of claim 4 in which said continuous film-forming silica precursor also includes colloidal silica.

6. The method of claim 1 in which said continuous film-forming silica precursor comprises a silsesquioxane having the general formula: $(RSiO_{3/2})_n$, where R comprises hydrogen, a hydroxy group, a low carbon alkyl, alkenyl or alkoxy group, where R can be a different one of the foregoing at different points along the length of the polymer chain and where n is within the range of 5 to 100.

7. The method of claim 6 in which said continuous film-forming silica precursor also includes colloidal silica.

8. The method of claim 1 in which said silica precursor comprises hydrido silsesquioxane.

9. The method of claim 1 in which said silica precursor comprises methylsilsesquioxane.

10. The method of claim 1 in which said silica precursor comprises ethoxymethylpolysiloxane and colloidal silica.

## Patentansprüche

1. Verfahren zum Schutz von Supraleitern auf Basis von Cupraten, bei dem man
   das supraleitende Material mit einer organischen Lösung eines einen kontinuierlichen Film bildenden Vorläufermaterials für Siliciumdioxid beschichtet, wobei das organische Lösungsmittel für diese Lösung ein solches ist, das sich bei einer Temperatur unterhalb von 400°C und unterhalb irgendeiner Temperatur verflüchtigt, bei der das Lösungsmittel in erheblichem Ausmaß mit dem Supraleiter auf Cupratbasis reagieren würde;
   das Lösungsmittel von dem beschichteten Supraleiter verdampft; und
   die Beschichtung in einer Sauerstoff enthaltenden Atmosphäre bei einer erhöhten Temperatur im Bereich von 300 bis 400°C zu Siliciumdioxid pyrolysiert.

2. Verfahren nach Anspruch 1, wobei das einen kontinuierlichen Film bildende Vorläufermaterial für Siliciumdioxid Tetraethylorthosilikat enthält.

3. Verfahren nach Anspruch 2, wobei das einen kontinuierlichen Film bildende Vorläufermaterial für Siliciumdioxid auch kolloidales Siliciumdioxid einschließt.

4. Verfahren nach Anspruch 1, wobei das einen kontinuierlichen Film bildende Vorläufermaterial für Siliciumdioxid Ethylpolysilikat enthält.

5. Verfahren nach Anspruch 4, wobei das einen kontinuierlichen Film bildende Vorläufermaterial für Siliciumdioxid auch kolloidales Siliciumdioxid einschließt.

6. Verfahren nach Anspruch 1, wobei das einen kontinuierlichen Film bildende Vorläufermaterial für Siliciumdioxid ein Silsesquioxan der allgemeinen Formel $(RSiO_{3/2}/_n$ enthält, in der R Wasserstoff, eine Hydroxylgruppe oder einen Alkyl-, Alkenyl- oder Alkoxyrest mit niedriger Kohlenstoffzahl bedeutet, wobei R an verschiedenen Punkten längs der Polymerkette verschiedene der genannten Bedeutungen haben kann; und in der n im Bereich von 5 bis 100 liegt.

7. Verfahren nach Anspruch 6, wobei das einen kontinuierlichen Film bildende Vorläufermaterial für Siliciumdioxid kolloidales Siliciumdioxid einschließt.

8. Verfahren nach Anspruch 1, wobei das Vorläufermaterial für Siliciumdioxid Hydridosilsesquioxan enthält.

9. Verfahren nach Anspruch 1, wobei das Vorläufermaterial für Siliciumdioxid Methylsilsesquioxan enthält.

10. Verfahren nach Anspruch 1, wobei das Vorläufermaterial für Siliciumdioxid Ethoxymethylpolysiloxan sowie kolloidales Siliciumdioxid enthält.

## Revendications

1. Un procédé pour la protection de supraconducteurs cuprates comprenant les opérations consistant :
   à revêtir le matériau supraconducteur d'une solution organique d'un précurseur de silice formant un film continu, le solvant organique pour ladite solution étant propre à se volatiliser à des températures inférieures à 400 °C et inférieures à toute température à laquelle le solvant pourrait réagir appréciablement avec le supraconducteur cuprate ;
   à chasser par évaporation ledit solvant dudit supraconducteur revêtu ; et
   à pyrolyser ledit revêtement en le transformant en silice dans une atmosphère contenant de l'oxygène à une température se situant dans l'intervalle de 300 à 400 °C.

2. Le procédé de la revendication 1 dans lequel ledit précurseur de silice formant un film continu comprend de l'orthosilicate de tétraéthyle.

3. Le procédé de la revendication 2 dans lequel ledit précurseur de silice formant un film continu renferme aussi de la silice colloïdale.

4. Le procédé de la revendication 1 dans lequel ledit précurseur de silice formant un film continu comprend du polysilicate d'éthyle.

5. Le procédé de la revendication 4 dans lequel ledit précurseur de silice formant un film continu renferme aussi de la silice colloïdale.

6. Le procédé de la revendication 1 dans lequel ledit précurseur de silice formant un film continu comprend un silsesquioxane répondant à la formule générale $(RSiO_{3/2})_n$, où R est un atome d'hydrogène, un groupe hydroxyle ou un groupe alkyle, alcényle ou alcoxy inférieur, R pouvant être différents substituants ci-dessus en des points différents le long de la chaîne moléculaire et n se situant dans l'intervalle de 5 à 100.

7. Le procédé de la revendication 6 dans lequel ledit précurseur de silice formant un film continu renferme aussi de la silice colloïdale.

8. Le procédé de la revendication 1 dans lequel ledit précurseur de silice comprend un hydrurosilsesquioxane.

9. Le procédé de la revendication 1 dans lequel ledit précurseur de silice comprend un méthylsilsesquioxane.

10. Le procédé de la revendication 1 dans lequel ledit précurseur de silice renferme un éthoxyméthylpolysiloxane et de la silice colloïdale.